(19) Europäisches Patentamt / European Patent Office / Office européen des brevets

(11) **EP 4 283 512 A1**

(12) **EUROPEAN PATENT APPLICATION**

(43) Date of publication:
**29.11.2023  Bulletin 2023/48**

(21) Application number: **22175486.4**

(22) Date of filing: **25.05.2022**

(51) International Patent Classification (IPC):
**G06F 30/27** (2020.01)   **G06N 3/08** (2023.01)
**G06N 5/00** (2023.01)   **G06N 20/00** (2019.01)

(52) Cooperative Patent Classification (CPC):
**G06N 3/08; G06F 30/27; G06N 20/00;** G06N 5/01

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **msg Life Central Europe GmbH
80687 München (DE)**

(72) Inventor: **Helmert, Axel
1040 Wien (AT)**

(74) Representative: **Patentanwälte Bauer Vorberg Kayser
Partnerschaft mbB
Goltsteinstraße 87
50968 Köln (DE)**

(54) **METHOD AND SYSTEM FOR MIGRATING A STARTING COMPUTATION MODEL TO A TARGET COMPUTATION MODEL**

(57)   The invention concerns a method for migrating a starting computation model (3) to a target computation model (4), wherein the target computation model (4) replicates the starting computation model (3), wherein the starting computation model (3) and the target computation model (4) are implemented via respective computer program code and configured to compute a respective vector interface output (6) based on a respective vector interface input (5), wherein the target computation model (4) comprises a plurality of sub-models (7a, b, c) configured to compute a respective output quantity (14a, b, c) from a respective input quantity (15a, b, c), wherein a first set (9) of sub-models (7a, b) of the plurality consists of a respective neural network (8a, b), wherein a second set (11) of sub-models (7c) of the plurality consists of a respective analytic computation model (10), wherein an intermediate quantity (13a, b) is comprised by the output quantity (14a, b) of a sub-model (7a, b) of the first set (9), which intermediate quantity (13a, b) is comprised by the input quantity (15) of an interior sub-model (16), which interior sub-model (16) is comprised by the second set (11), wherein the sub-models (7a, b) of the first set (9) are trained through machine learning based on a plurality of vector training data sets, which plurality of vector training data sets conforms to the vector interface output (6) and the vector interface input (5) of the starting computation model (3). The invention also concerns a corresponding system.

Fig. 1

EP 4 283 512 A1

## Description

The present invention concerns a method for migrating a starting computation model to a target computation model and a system for migrating a starting computation model to a target computation model.

Computation models to simulate various processes are known from a wide variety of fields. In particular, it is known to use computer simulations of chemical, physical and engineering processes. Such computer simulations are implemented in software. By setting various input variables and boundary conditions, usually corresponding to settings, user control input or boundary conditions of the corresponding physical, chemical or technical process, output variables may be computed which describe the expected outcome of the process in question in real life.

In this way, a wide variety of processes, including experiments, may be simulated to arrive at results which may reflect real outcomes to some extent.

However, not all existing such computer simulations have been built using first principles. Though the basic equations and rules underlying many physical, chemical or technical processes are well understood and readily available, basing a simulation strictly on such equations and rules may not be practically viable. For example, the scale of the phenomenon to be simulated may be much larger than that which is described by the equations so that relying on first principles may not even be feasible in terms of computation power or the time necessary for a particular computation. For the description of some phenomena, in particular such large scale processes, some ad-hoc simulation sub-models may have been programmed, perhaps progressively over longer periods of time such as many years. Thus, there exist legacy computer simulations which are found to produce results that have been found accurate enough in practice, but which have continuously evolved over time with a variety of modifications and jury-rigged code. This means that new features or aspects of the simulation may not easily be added, For example, an existing simulation software may work well enough for a fixed temperature of a certain substance, but may not have any provisions for adding temperature dependency for that substance as a new feature. If the legacy system is based on code that has evolved ad-hoc over a long time, there is no straightforward way to add such a temperature dependency, in particular if the temperature in question is not explicitly reflected in a known variable of the simulation software.

At some point in time, the need arises to migrate the computer simulation from its legacy computer system to a new computer system. This process may be described as migrating the starting computation model to a target computation model. This may also be an opportunity to refactor the software code, which at this point may have been unwieldy, difficult to understand and which may rely on features of the legacy system, e.g. the operating system of the legacy computer simulation, which are no longer available or at least no longer available in their old form on the new system.

Also, the new hardware or operating system migrated to may not support the programming languages used for the legacy computer system. Even if such support exists, it may be that using a different programming language or a new programming paradigm may be advantageous for reasons of software engineering or for speeding up the execution of the computer simulation on the new platform. Such a migration to a new computer system presents a suitable opportunity to, on the one hand, refactor the software code and also to compartmentalize functions. The legacy computer simulation provides a reference point for a "correct" simulation, but may not be structured in a way that reflects analytic connections underlying the simulation. On the other hand, without the benefit of a clear structure in the code of the legacy computer system, any software migration or refactoring is an extremely time-consuming, in terms of man-years, process, especially if it is to be ensured that the migrated and refactored system is to produce identical results to those of the legacy system.

The problem of the invention is solved by a method for migrating a starting computation model to a target computation model with the features of claim 1. The problem of the invention is also solved by a system for migrating a starting computation model to a target computation model with the features of claim 16.

Underlying the invention is the realization that an existing or starting computation model may be replicated by a target computation model which comprises both analytic sub-modules, which reflect known analytic connections between certain quantities and general knowledge of the mechanisms underlying the simulation, as well as neural network sub-modules. These neural network sub-modules are trained with the data provided by the pre-existing legacy computation model. They reproduce the computational logic of the legacy computation model that is known to be the correct but for which an analytic description does not exist, at least not yet.

On the other hand, the known analytic connections and interrelations become an explicit, identifiable and compartmentalized part of the target computation model, which is then easier to expand upon. Thus, the migration provides the opportunity to rely on the legacy simulation that is known to produce results that are "correct" in order to arrive at a new simulation system that is equally correct in its result, but which is structured more clearly internally. Such a clearer internal structure then also makes it easier to add new functionality and simulation complexity, e.g. adding the temperature dependency as described.

The approach according to the invention also significantly reduces the effort to match the starting computation model with the target computation model. Instead of implementing a "hard-wired" target computation model, comparing it to the starting computation model over various inputs and then "manually" fine-tweaking it when differences arise, deliberately "blank" parts are left in the target computation model, corresponding to untrained neural networks. These "blank" parts are then filled by training the neural networks. Not only is that learning process substantially automatic and therefore requires few man-years in personnel costs, but it also gravitates by the nature of the process itself toward replication of the starting computation model.

The method according to the invention is for migrating a starting computation model to a target computation model, wherein the target computation model replicates the starting computation model, wherein the starting computation model and the target computation model are implemented via respective computer program code and configured to compute a respective vector interface output based on a respective vector interface input. The computer program code of the starting computation model and of the target computation model, respectively, may be either configured to run on the same kind of computer system or operating system or configured to run on different kinds of computer systems or operating systems. Likewise, the programming language of the respective computer program code may be given in the same programming language or in different programming languages.

The respective vector interface input may in principle be any kind of multivariate input. Likewise, the respective vector interface output may in principle be any kind of multivariate output. Preferably, the vector interface input for the starting computation model is identical to the vector interface input for the target computation model. Thus, the number and type of the parameters of the vector interface input of the starting computation model is identical to the number and type of the parameters of the vector interface input of the target computation model. Likewise, it is preferred that the vector interface output for the starting computation model is identical to the vector interface output for the target computation model. The actual values entered for the vector interface input for the respective computation models may be, of course, different.

That the target computation model replicates the starting computation model means that for substantially any vector interface input, i.e. for any set of values that make up the vector interface input, both the target computation model and the starting computation model compute a respective vector interface output that is substantially identical. Preferably, this means that for at least 95 % of possible vector interface input values, preferably at least 99 % of possible vector interface input values, the vector interface output - more specifically the vector interface output values - of the target computation model differs by less than 1 %, preferably less than 0.1 %, from the vector interface output of the starting computation model. Further preferably, for the remaining 5 % or 1 % of possible vector interface input values, the vector interface output of the target computation model differs by less than 5 % and preferably less than 1 % from the vector interface output of the starting computation model. It may also be that a percentage difference limit between the vector interface output of the target computation model and the vector interface output of the starting computation model is user-defined. Equally, the minimum percentage of possible vector interface input values for which the given percentage difference limit between the vector interface output of the target computation model and the vector interface output of the starting computation model applies may also be user-defined.

In addition, or as an alternative to any percentage difference limit between the vector interface output of the target computation model and the vector interface output of the starting computation model, there may also be an absolute difference limit between the vector interface output of the target computation model and the vector interface output of the starting computation model. Such an absolute difference limit may be pre-defined or user-defined. The minimum percentage of possible vector interface input values for which the absolute difference limit applies may in principle have any arbitrary value, either pre-defined or user-defined, but is preferably equal to the minimum percentage of possible vector interface input values for which the given percentage difference limit applies.

In the method according to the invention, the target computation model comprises a plurality of sub-models configured to compute a respective output quantity from a respective input quantity, wherein a first set of sub-models of the plurality consists of a respective neural network and wherein a second set of sub-models of the plurality consists of a respective analytic computation model. Thus, the target computation model has different sub-models, at least one of which is a neural network and at least one other of which is an analytic computation model. The analytic computation model is a model which computes its output from its input in a pre-defined manner, i.e. in a manner which has not been learned by training - as is the case for the neural network but rather one which has been prescribed a priori. An analytic computation model may also be denoted as a static computation model. It may be that the target computation model consists only of sub-modules which are either a neural network or a analytic computation model. The input quantity as well as the output quantity may be either a scalar quantity or a vector quantity, respectively.

It is to be noted that both the first set of sub-models and the second set of sub-models may consist of only a single sub-model, respectively, in the first set or in the second set.

In the method according to the invention, an intermediate quantity is comprised by the output quantity of a sub-model of the first set, which intermediate quantity is comprised by the input quantity of an interior sub-model, which interior sub-model is comprised by the second set. In other words, there is a sub-model among the neural networks, the output of which functions as an input - potentially with additional quantities - to a sub-model which is an analytic computation model. This sub-model which is an analytic computation model is denoted as interior sub-model because its input quantity comprises the output quantity of another sub-model. Thus, the sub-model which is an analytic computation model processes a quantity that is "interior" to the model in its entirety, i.e. the intermediate quantity. In principle, that intermediate quantity may be any quantity. Many systems to be simulated may be described by a quantity which itself may not be trivial to determine, but from which some other quantities may be analytically derived. For example, the total energy in a system may not be easy to determine analytically, but once it is determined, it may form the basis to determine other quantities in an analytical way. Thus, having such an intermediate quantity makes it possible to compartmentalize the target computation model into sub-models, some of which are analytic, in order to also arrive at smaller sub-models which are neural networks, thereby making the smaller neural networks easier to train.

Further in the method according to the invention, the sub-models of the first set are trained through machine learning based on a plurality of vector training data sets, which plurality of vector training data sets conforms to the vector interface output and the vector interface input of the starting computation model. This means that the plurality of vector training data sets was not necessarily generated by the starting computation model. However, if the vector interface input data of the vector training data sets were entered into the starting computation model, the corresponding vector interface output data of the vector training data sets would be output by the starting computation model.

It may be for any sub-model of the first set that the set of all possible values of the input quantity or input quantities is small. Consequently, for that sub-model the set of all possible output values is also small. In such a situation it may not make sense to train a neural network in the strict sense, because a corresponding decision tree, which is very simple to implement, may be easy to determine and to store. Such a decision tree can be technically implemented like a neural network. It is then also referred to as a neural tree. Effectively, such a neural tree is a particular way of implementing a look-up table. One advantage is that the target system does not have to technically distinguish between decision trees and neural trees. Thus, according to a further preferred embodiment of the method according to the invention, when training the sub-models of the first set through machine learning, it is decided whether a sub-model of the first set may be implemented by a decision tree, which decision tree matches any input quantity data of that sub-model to a respective output quantity data of that sub-model. Further, when the decision is made to implement a sub-model of the first set by a decision tree, that sub-model of the first set is implemented by the decision tree that matches any input quantity data of that sub-model to a respective output quantity data of that sub-model. That decision tree is determined by the plurality of vector training data sets.

According to a preferred embodiment of the method according to the invention, , the target computation model is executed on a computing hardware system after completion of the machine learning so that the target computation model computes vector interface output data based on vector interface input data. It is further preferred that the target computation model is applied to new vector interface input data, which are distinct from the vector training date sets, to compute new vector interface output data. Thus, after completion of the machine learning so that the target computation model computes new vector interface output data based on new vector interface input data. Preferably, the new vector interface input data has not been input to the starting computation model. In other words, after migrating to the target computation model, the target computation model is used for simulation based on data that has not been the basis for a simulation before, not even by the starting computation model.

It may be that the starting computation model which is migrated is not the first computation model for which the migration is performed. In other words, there may exist a previous starting computation model which has been migrated to a previous target computation model. In that context, it may be that the starting computation model to be migrated at hand is defined in terms of a difference or delta with respect to the previous starting computation model. In that case, also the target computation model can be defined in terms of a difference or delta to the previous target computation model. A further preferred embodiment of the method according to the invention is characterized in that a previous starting computation model has been migrated to a previous target computation model, that the starting computation model is defined as a delta model with respect to the previous starting computation model and that the target computation model is defined as a delta model with respect to the previous target computation model. Preferably, for the delta model with respect to the previous starting computation model, the vector interface output for any vector interface input data is defined by a difference vector to the vector interface output of the previous starting computation model for that vector interface input data. Further preferably, for the delta model with respect to the previous target computation model, the vector interface output for any vector interface input data is defined by a difference vector to the vector interface output of the previous target computation model for that vector interface input data. In particular for training the neural networks, the restriction to such a difference to an existing target computation model makes the training more efficient.

In principle, it may be that there is only a single intermediate quantity. According to a preferred embodiment of the method according to the invention, a plurality of intermediate quantities is comprised by at least one output quantity of at least one sub-model of the first set, wherein each intermediate quantity of the plurality of intermediate quantities is comprised by a respective input quantity of a respective interior sub-model, wherein each interior sub-model is comprised by the second set. Thus, in the preferred embodiment there is more than one intermediate quantity. Having more than one intermediate quantity permits even more compartmentalization of the target computation model.

In principle, the intermediate quantity may be wholly internal to the simulated system and therefore not part of the vector interface output of the starting computation model. Yet according to a further preferred embodiment of the method according to the invention, the intermediate quantity is comprised by the vector interface output. Thus, values for the intermediate quantity are also provided by the starting computation model. In the case of more than intermediate quantity, it is preferred that each intermediate quantity of the plurality of intermediate quantities is comprised by the vector interface output.

In principle, the input quantity of the interior sub-model may be a scalar quantity. A preferred embodiment of the method according to the invention is characterized in that the input quantity of the interior sub-model is a vector input quantity of the interior sub-model, This means that it is a multivariate input quantity of the interior sub-model.

It may be that this vector input quantity exclusively comprises quantities which are internal to the computation model. A further preferred embodiment of the method according to the invention is characterized in that the vector input quantity of the interior sub-model comprises an interface input quantity which is comprised by the vector interface input.

In principle, there may only be a single sub-model for which the input quantity is a vector quantity or even no such sub-model at all. According to a preferred embodiment of the method according to the invention, for a plurality of sub-models the input quantity is a vector input quantity.

In principle, it may be that the method according to the invention is complete after the migration to the target computation model has been finished, the neural networks trained and the target computation model is executed. However, when such a legacy computer simulation, i.e. the starting computation model, exists which is accurate enough for practical purposes and when this simulation is then migrated and refactored, clearly some practical solution to the problem of simulation and to providing a clearer internal structure has been found. However, to the extent that that solution is based on the implicit discovery of some rule, equation or other formulaic expression for the process that is being simulated or for a sub-process thereof, that implicit discovery remains hidden in the interactions of the various pieces of code developed over time. In the absence of further steps, this holds true both for the starting computation model as well as for the target computation model. Consequently, that hidden or implicit "discovery" cannot be easily extracted and used for a different computer simulation or in a different simulation context or just to apply that insight to some other physical or chemical process. Even in the case when such extraction is possible, it is a very time-consuming taking many man-years to complete, with the verification of the extraction being very time-consuming in its own right.

Consequently, there is a need to be able to extract such implicit findings of equations and the like from computation models that have been refactored from legacy computation models. To that end, once the target computation model replicating the starting computation model is complete, a parameterized metamodel may be matched to the target computation model or a part thereof to analytically describe at least a part of the computational relationships implemented by the target computation model.

Therefore, a preferred embodiment of the method according to the invention is characterized in that, after completion of the machine learning an analytic model is matched to at least a part of the target computation model to determine analytic expressions which at least partially describe the dependency of the vector interface output of the target computation model from the vector input. In other words, an analytic model which may be described by various parameters is fitted to match either the target computation model in its entirety or to specific parts of the target computation model. The analytic model consists of analytic expressions and thus the fitted analytic model provides at least a partially analytic description of the dependencies within the target computation model. It may also be that the determined analytic expression fully describes the dependency of the vector interface output of the target computation model from the vector interface input. In addition to being able to provide such an analytic representation of the target computing model, the process itself is also automatic. Therefore, the man-years normally necessary for such an undertaking may be saved by automating the process.

Obtaining such an analytic model and the analytic description it provides on the one hand makes adding extensions to the simulation as described above even easier. More importantly, by exposing underlying connections and interrelations and identifying them with analytic expressions permits adjusting process parameters of actual technical, physical or technical processes to obtain improved process results. For example, the exposed analytic expression may show that a certain combination of process parameters leads to better durability of the resulting alloy. An engine may turn out to have better longevity when operated during certain conditions.

In principle, the metanalytic model may be a composition of any functions. In particular it may be composed of multivariate function. Yet according to a further preferred embodiment of the method according to the invention, the metanalytic model is a composition of univariate, preferably parametrized, functions. Having a composition of univariate parametrized functions makes the fitting process for the metanalytic model easier.

Generally speaking, the univariate parametrized functions may be any kind of function which is univariate and parameterized. A preferred embodiment of the method according to the invention is characterized in that the model is a parameterized metamodel and that the univariate parametrized functions are instances of Meijer G-functions. The parameterized metamodel may also be called a symbolic metamodel. A metamodel may be understood to be a model of models. A Meijer G-function is a very general function, defined as a line integral in the complex plane, which has most known special functions as particular cases. Moreover, the set of Meier G-functions is closed both for differentiation and for integration. The definition of the Meijer G-function is provided starting on page 206 of "Higher Transcendental Functions, Vol. I" by Bateman and Erdelyi (1953). Consequently, Meijer G-functions are univariate functions very well suited to provide the components for the metamodel.

Some such particular cases of the Meijer G-functions are given in the following. $G_{3,1}^{0,1}\left(\begin{matrix}2,2,2\\1\end{matrix}\Big|x\right)$ is equivalent to $x$. $G_{0,1}^{1,0}\left(\begin{matrix}-\\0\end{matrix}\Big|x\right)$ is equivalent to $e^{-x}$. $G_{2,2}^{1,2}\left(\begin{matrix}1,1\\1,0\end{matrix}\Big|x\right)$ is equivalent to $\log(1 + x)$. $G_{0,2}^{1,0}\left(\begin{matrix}-\\0,\frac{1}{2}\end{matrix}\Big|\frac{x^2}{4}\right)$ is equivalent to $\frac{1}{\sqrt{\pi}}\cos x$. $G_{2,2}^{1,2}\left(\begin{matrix}\frac{1}{2},1\\\frac{1}{2},0\end{matrix}\Big|x\right)$ is equivalent to 2 arctan (x).

It is preferred that each instance of a Meijer G-function is parametrized with a plurality of parameters. This may also be expressed in that each instance of a Meijer G-function is parameterized multivariate.

Generally speaking, any particular cases of the Meijer G-function may be used for the parameterized metamodel. A further preferred embodiment of the method according to the invention is characterized in that the parameterized metamodel is given by

$$G\left(\mathbf{x};\,\theta\right) = \sum_{i=0}^{r} G_{p,q}^{m,n}\left(\theta_i^{out}\Big|\sum_{j=1}^{d} G_{p,q}^{m,n}\left(\theta_{ij}^{in}\big|x_j\right)\right)$$

wherein $\theta = (\theta^{out}, \theta^{in})$, $\theta^{out} = (\theta_0^{out}, ..., \theta_r^{out})$ and

$$\theta^{in} = \left\{\left(\theta_{i1}^{in}, ..., \theta_{id}^{in}\right)\right\}_i$$ are the parameters of the metamodel, wherein $G_{p,q}^{m,n}(\theta|x) = G_{p,q}^{m,n}\left(a_p, b_q|x\right)$, $\theta = (a_p, b_q)$ and wherein x is the vector interface input. The number of the parameters of the metamodel as well as their starting value may be chosen as appropriate. According to a preferred embodiment of the method according to the invention, matching the parameterized metamodel to determine the analytic expressions comprises optimizing the parameterized metamodel. That optimization makes the behavior of the parameterized metamodel approach that of the target computation model. That target computation model in turn replicates the starting computation model. It follows that said optimization also makes the behavior of the parameterized metamodel approach that of the target computation model. In principle, any kind of optimization of the parameterized metamodel may be used. Preferably, matching the parameterized metamodel to determine the analytic expressions comprises optimizing the parameterized metamodel through gradient descent. Here, any appropriate method of gradient descent may be used.

According to a further preferred embodiment of the method according to the invention, optimizing the parameterized metamodel comprises minimizing an error metric. Preferably, the error metric to be minimized is the mean squared error between the output of the parameterized metamodel and the output of the target computation model. Here it is further preferred that minimizing the error metric means that for any vector interface input, the difference between the output of the parameterized metamodel and the output of the target computation model is less than 0.5 %. This limit may apply to each variable of the vector interface output individually. It may also be that for all variables of the vector interface output the total difference is less than 0.5 %.

As already stated, the analytic model is matched to at least a part of the target computation model. That part of the target computation model may in particular correspond to one or more sub-models of the plurality of sub-models. In particular, it may be that the analytic model is matched to at least one of the neural networks. It may also be that the analytic model is matched to the entire target computation model.

Alternatively or in addition to the matching of the parameterized metamodel as described above, further approaches may be applied to obtain an analytic model for matching the target computation model. According to a preferred embodiment of the method according to the invention, the analytic model is fitted by symbolic regression.

It may also be that a plurality of analytic models is matched to a respective part of the target computation model to determine analytic expressions which at least partially describe the dependency of the vector interface output of the target computation model from the vector interface input. In particular, it may be that the plurality of analytic models comprises a parameterized metamodel and further comprises an analytic model fitted by symbolic regression.

When the plurality of analytic models is matched to a respective part of the target computation model, those respective parts of the target computation model may be associated with the analytic models in different ways. In on embodiment, the plurality of analytic models is associated with different sub-models of the first set. In particular, it is preferred that at least one first analytic model from the plurality of analytic models is matched to a first sub-set of sub-models of the first set and at least one second analytic model from the plurality of analytic models is matched to a second sub-set of sub-models of the first set. In other words, different analytic models are matched with different sub-models of the target computation model, which correspond to different "logical blocks" or "functional blocks" within the target computation model.

The first sub-set of sub-models may consist of one sub-model but may also comprise more than one sub-model. Equally, the second sub-set of of sub-models may consist of one sub-model but may also comprise more than one sub-model. Preferably, the first sub-set of sub-models is disjoint from the second sub-set of sub-models.

In addition, or as an alternative of assigning different analytic models from the plurality of analytic models to different sub-models of the target computation model, different analytic models from the plurality of analytic models may be matched to at least a part of the target computation model depending on the values of the vector interface input. Therefore, it is preferred that at least one first analytic model from the plurality of analytic models is matched to at least a part of the target computation model for a first input value space of the vector interface input and that at least one second analytic model from the plurality of analytic models is matched to at least a part of the target computation model for a second input value space of the vector interface input. Here, the first input value space and the second input value space define respective sets of possible input values of the vector interface input. In this way and by way of example for a chemical process modelled by the target computation model, different analytic models may be matched to the target computation model for high temperatures and high pressure values on the one hand as well as low temperatures and low pressures values on the other hand. The underlying reason may be that the process to be modelled differs significantly in its nature between the two process parameter regimes. Preferably, the first input value space of the vector interface input is disjoint from the second input value space of the vector interface input.

Further it may also be that different analytic models from the plurality of analytic models may be matched to a sub-model of the first sub-set of sub-models depending on the values of the input quantity of the submodel. This preferred embodiment corresponds to the above-described embodiment with the dependence on the vector interface input values, but in this case there is a dependence on the input quantity of the particular submodel rather than of the target computation model. Here it is preferred that a first analytic model from the plurality of analytic models is matched to a sub-model of the first set of sub-models for a first input quantity space of the input quantity of that sub-model and that a second analytic model from the plurality of analytic models is matched to the sub-model of the first set of sub-models for a second input quantity space of the input quantity of that sub-model. Preferably, the first input quantity space is disjoint from the second input quantity space. The submodel of the first set of sub-models in question here may also be denoted as switched sub-model.

The at least one first analytic model may comprise a parameterized metamodel. The at least one second analytic model may comprise a model fitted by symbolic regression.

As already stated, in principle the plurality of vector training data sets may be provided by any suitable method. A preferred embodiment of the method according to the invention is characterized in that the plurality of vector training data sets is generated by applying vector training input data sets of the vector training data sets to the starting computation model to compute corresponding vector training output data sets of the vector training data sets. This clearly ensures compliance of the vector training data sets with the starting computation model.

In principle, the vector interface output may comprise variables that correspond to any quantity, in particular any physical or chemical quantity. A further preferred embodiment of the method according to the invention is characterized in that the vector interface input comprises a input time variable. In other words, the vector interface input comprises an input quantity with which describes either a relative or an absolute time. For example, the starting computation model may describe a chemical reaction. In this case, the vector interface input may comprise variables describing the kind and quantity of educts provided to the chemical reaction. The vector interface output may in turn comprise variables describing the concentrations of products of the chemical reaction as well as a resulting temperature and pressure. When the vector interface input also comprises an input time variable, the starting computation model may determine said concentrations of products of the chemical reaction as well as said temperature and pressure for point in time corresponding to the input time variable. That point in time may be described as the time passed after the start of the reaction.

As an alternative or in addition to the input time variable comprised by the vector interface input, the vector interface output may comprise an output time variable. That output time variable may give a relative time or an absolute time in which For example, if in the case of the chemical reaction described by the starting computation model as cited above the vector interface input does not comprise an input time variable, then the starting computation model may determine the quantities as described for different time spans after the start of the reaction, which different time spans may be output in the output time variable of the vector interface output.

The system according to the invention is for analytically describing a target computation model replicated from a starting computation model.

The system according to the invention comprises a computing arrangement with a starting computation model and with a target computation model, wherein the starting computation model and the target computation model are implemented via respective computer program code and configured to compute a respective vector interface output based on a respective vector interface input, wherein the target computation model comprises a plurality of sub-models configured to compute a respective output quantity from a respective input quantity, wherein a first set of sub-models of the plurality consists of a respective neural network, wherein a second set of sub-models of the plurality consists of a respective analytic computation model, wherein an intermediate quantity is comprised by the output quantity of a sub-model of the first set, which intermediate quantity is comprised by the input quantity of an interior sub-model, which interior sub-model is comprised by the second set.

The system according to the invention is configured to train the sub-models of the first set through machine learning based on a plurality of vector training data sets, which plurality of vector training data sets conforms to the vector interface output and the vector interface input of the starting computation model.

According to a preferred embodiment of the system according to the invention, the system is further configured to match an analytic model to at least a part of the target computation model to determine analytic expressions which at least partially describe the dependency of the vector interface output of the target computation model from the vector interface input after completion of the machine learning.

Preferred features, embodiments and properties of the method according to the invention correspond to those of the system according to the invention and vice versa.

Further features, properties, aims, effects and advantages of the present invention are illustrated in the following Figures which show one embodiment. It is shown in

Fig. 1   a schematic representation of an embodiment of a system according to the invention for executing the method according to the invention and

Fig. 2   a schematic representation of parts of the internal structure of the target computation model of the system of Fig. 1.

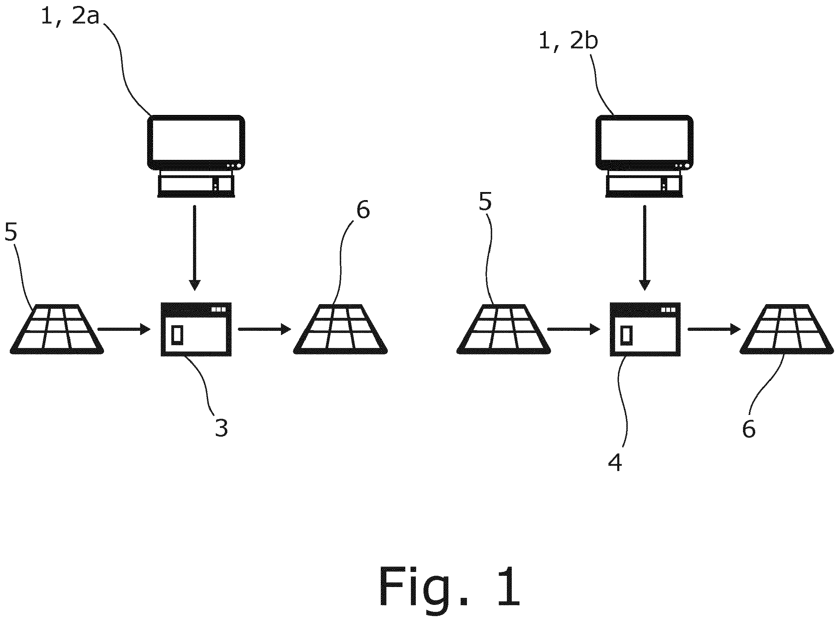

The system according to an embodiment of the invention shown in Fig. 1 comprises a computing arrangement 1, which in this embodiment consists of a first computer 2a and a second computer 2b.

The starting computation model 3 is a computer program implemented in C++ computer program code and running on the first computer 2a. The starting computation model 3 is configured to simulate the hydrodynamic drive of a construction vehicle. To that end, input data is provided to the starting computation model as vector interface input 5. This input data comprises both static information about the layout and dimensions of the hydrodynamic drive, including data about the diesel engine providing power for the hydrodynamics, as well as the user input during operation of the hydrodynamic drive over time, i.e. the control actions performed by a simulated user of the construction vehicle. The starting computation model 3 provides output data as a vector interface output 6. This output data comprises fluid pressure at various locations of the hydrodynamic drive, data concerning the output variables of different machines of the construction vehicle such as position and power and a time variable which denotes the point in time for which the other output data is valid. Variations of e.g. fluid pressure over time are described by having separate output data according to the vector interface output 6 where the time variable for each output data.

The target computation model 4 is a computer program implemented in Java computer program code and running on the second computer 2b. The first computer 2a and the second computer 2b use different operating systems, respectively.

The target computation model 4 is to replicate the working of the starting computation model 3. To that end, the target computation model 4 shares the data interface of the starting computation model 4 and may therefore take an identical vector interface input 5 as the starting computation model 4. In other words, the parameters and their data types of the input provided to the target computation model 4 is identical to that of the input provided to the starting computation model 3. In an analogous way, the target computation model 4 has the same vector interface output 6 as the starting computation model 3.

However, for replication it does not suffice for the starting computation model 3 and the target computation model 4 to have the same input interface and output interface. In addition, given the same vector interface input 5 with the same input data, the output data according to the vector interface output 6 of the starting computation model 3 and the target computation model 4 should be identical or at least very close.

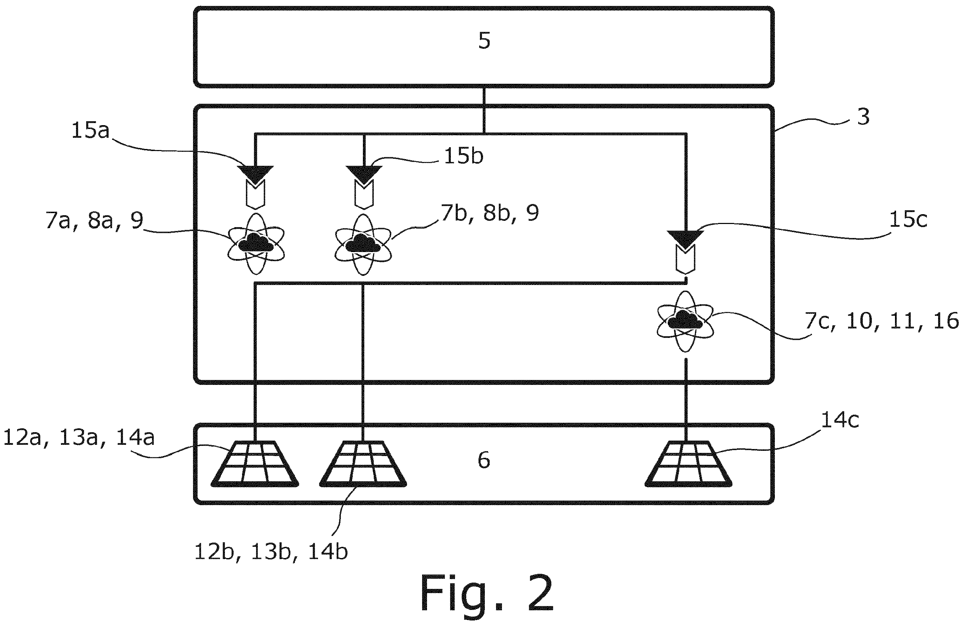

To that end, the target computation model 4 is sub-divided into a plurality of sub-models 7a, b, c, three of which are shown by way of example in Fig. 2. The first sub-model 7a and the second sub-model 7b are each a neural network 8a, 8b and form a first set 9 of sub-models. The third sub-model 7c is an analytic computation model 10 and forms - by itself - a second set 11 of sub-models. That is, the third sub-model 7c consists of an algorithmic implementation of a predefined analytic formula to determine - in this particular case - the force which a particular machine of the construction vehicle exerts at the particular point in time. That force can be analytically calculated if some other quantities known. Each sub-model 7a, b, c takes a respective input quantity 15a, b, c as input and produces as output a respective output quantity 14a, b, c.

In the present example, those other quantities include a first pressure value 12a and a second pressure value 12b of the hydrodynamic drive. However, neither the first pressure value 12a nor the second pressure value 12b is to be determined based on a predefined analytic formula. Instead the first neural network 8a, being the first sub-module 7a, is to determine the first pressure value 12a and the second neural network 8b, being the second sub-model 7b, is to determine the second pressure value 12b. Beside the first pressure value 12a and the second pressure value 12 b, the input quantity 15c of the third sub-model 7c also comprises further values, in particular corresponding control input from the user, from the vector interface input 4. These values from the vector interface 4 input are denoted as interface input quantities. Since the input quantity 15c of the third sub-model 7c comprises more than a single scalar value, it is a vector input quantity of the third sub-model 7c.

In the present example, the first pressure value 12a and the second pressure value 12b present a respective intermediate quantity 13a, b because they each are not only an output quantity 14a, b of a sub-model of the first set 9 of sub-models, but also each comprised by the input quantity 15c of the sub-model 7c of the second set 11 of sub-models. Such a sub-model 7c from the second set 11 for which the input quantity 15 comprises an output quantity from the first set 9 presents an interior sub-model 16.

Besides being comprised by the input quantity 15c of the third sub-model 7c, the first pressure value 12a and the second pressure value 12b are also comprised by the vector interface output 6. Moreover, the output quantity 14c of the third sub-model 7c is also comprised by the vector interface output 6.

With respect to the input quantities 15a, b of the first sub-model 7a and the second sub-model 7b, respectively, these are also vector input quantities and comprised by the vector interface input 4.

For the target computation model 4, the third sub-model 7c which is an analytic computation model 10 as well as any further sub-models that are analytic computation models 10 are already configured with their implementation and without the need for any training. The first sub-model 7a and the second sub-model 7b as well as any other sub-models that are a neural network 8a, b are trained through machine learning. To that end, a plurality of vector training data sets are used which have been generated by applying vector training input data sets to the starting computation model to determine vector training output data sets. Together with the vector training input data sets, there form the vector training data sets.

Once this machine learning is complete, the target computation model 4 as such is functional. Subsequently, the target computation model 4 is executed on the second computer 2b. Though the target computation model 4 may now accurately simulate the hydrodynamic drive, due to the neural networks there is not yet an analytic expression of the dependencies of the target computation model 4.

Therefore, a parameterized metamodel is matched to the target computation model 4. This parameterized metamodel is a composition of univariate Meijer G-functions. Virtually any analytic function is a particular case of a Meijer G-function. In other words, by choosing the appropriate parameters virtually any analytic function can be expressed by a Meijer G-function.

This matching of the parameterized metamodel to the target computation model 4 involves determining the parameters for the parameterized metamodel that will yield the closest possible approximation of the target computation model 4 by the parameterized metamodel. To that end, an error metric is applied to a difference between the results of the target computation model 4 and the parameterized metamodel, given the same data for the vector interface input 5 and the vector interface output 6 and the gradient descent method is used to minimize that error metric.

Once the minimization is complete, the resulting parameterized metamodel provides a decomposition of the entire target computation model 4, including the sub-models 7a, b that are neural networks 8a, b into analytic parts. In this way, hidden regularities and connections "hidden" in the target computation model 4 can be brought to light. Based on these regularities, optimizations may be applied either to the technical system itself being simulated, e.g. by amending the design of the hydrodynamic drive, or to the control of that technical system by the user. For example, it may be determined that controlling the construction vehicle differently leads to more effective outcomes.

**Claims**

1. Method for migrating a starting computation model (3) to a target computation model (4), wherein the target computation model (4) replicates the starting computation model (3), wherein the starting computation model (3) and the target computation model (4) are implemented via respective computer program code and configured to compute a respective vector interface output (6) based on a respective vector interface input (5), wherein the target computation model (4) comprises a plurality of sub-models (7a, b, c) configured to compute a respective output quantity (14a, b, c) from a respective input quantity (15a, b, c), wherein a first set (9) of sub-models (7a, b) of the plurality consists of a respective neural network (8a, b), wherein a second set (11) of sub-models (7c) of the plurality consists of a respective analytic computation model (10), wherein an intermediate quantity (13a, b) is comprised by the output quantity (14a, b) of a sub-model (7a, b) of the first set (9), which intermediate quantity (13a, b) is comprised by the input quantity (15) of an interior sub-model (16), which interior sub-model (16) is comprised by the second set (11), wherein the sub-models (7a, b) of the first set (9) are trained through machine learning based on a plurality of vector training data sets, which plurality of vector training data sets conforms to the vector interface output (6) and the vector interface input (5) of the starting computation model (3).

2. Method according to claim 1, **characterized in that** a plurality of intermediate quantities (13a, b) is comprised by at least one output quantity (14a, b) of at least one sub-model (7a, b) of the first set (9), wherein each intermediate quantity (13a, b) of the plurality of intermediate quantities (13a, b) is comprised by a respective input quantity (15c) of a respective interior sub-model (16), wherein each interior sub-model (16) is comprised by the second set (11).

3. Method according to claim 1 or 2, **characterized in that** the intermediate quantity (13a, b) is comprised by the vector interface output (6), preferably, that each intermediate quantity (13a, b) of the plurality of intermediate quantities (13a, b) is comprised by the vector interface output (6).

4. Method according to one of claims 1 to 3, **characterized in that** the input quantity (15c) of the interior sub-model (16) is a vector input quantity of the interior sub-model (16).

5. Method according to claim 4, **characterized in that** the vector input quantity of the interior sub-model (16) comprises an interface input quantity which is comprised by the vector interface input (4).

6. Method according to claim 4 or 5, **characterized in that** for a plurality of sub-models (7a, b, c) the input quantity is a vector input quantity.

7. Method according to one of claims 1 to 6, **characterized in that** after completion of the machine learning an analytic model is matched to at least a part of the target computation model (4) to determine analytic expressions which at least partially describe the dependency of the vector interface output (6) of the target computation model (4) from the vector interface input (5).

8. Method according to claim 7, **characterized in that** the analytic model is a composition of univariate, preferably, parametrized functions.

9. Method according to claim 8, **characterized in that** the analytic model is a parameterized metamodel and that the univariate parametrized functions are instances of Meijer G-functions, preferably, that each instance of a Meijer G-function is parametrized with a plurality of parameters.

10. Method according to claim 9, **characterized in that** the parameterized metamodel is given by

$$G\left(\mathbf{x};\,\theta\right) = \sum_{i=0}^{r} G_{p,q}^{m,n}\left(\theta_i^{out}\Big|\sum_{j=1}^{d} G_{p,q}^{m,n}\left(\theta_{ij}^{in}\big|x_j\right)\right)$$

wherein $\theta = (\theta^{out},\,\theta^{in})$, $\theta^{out} = (\theta_0^{out},\,...,\,\theta_r^{out})$ and $\theta^{in} = \left\{\left(\theta_{i1}^{in},\,...,\,\theta_{id}^{in}\right)\right\}_{i}$, wherein $G_{p,q}^{m,n}(\theta|x) = G_{p,q}^{m,n}\left(\boldsymbol{a}_p,\boldsymbol{b}_q|x\right)$, $\theta = (a_p,b_q)$, wherein the $\theta_i^{i'}$ are the respective univariate parameter for each Meijer G-function, and x is the vector interface input.

11. Method according to one of claims 7 to 10, **characterized in that** matching the parameterized metamodel to determine the analytic expressions comprises optimizing the parameterized metamodel, preferably through gradient descent.

12. Method according to claim 11, **characterized in that**, optimizing the parameterized metamodel comprises minimizing an error metric.

13. Method according to one of claims 7 to 12, **characterized in that** the analytic model is matched to at least one of the neural networks (8a, b).

14. Method according to one of claims 1 to 13, **characterized in that** the plurality of vector training data sets is generated by applying vector training input data sets of the vector training data sets to the starting computation model (3) to compute corresponding vector training output data sets of the vector training data sets.

15. Method according to one of claims 1 to 14, **characterized in that** the vector interface input (4) comprises an input time variable, preferably, that the vector interface output (6) comprises an output time variable.

16. System for migrating a starting computation model (3) to a target computation model (4), which target computation model (4) is replicated from a starting computation model (3), wherein the system comprises a computing arrangement (1) with the starting computation model (3) and with the target computation model (4), wherein the starting computation model (3) and the target computation model (4) are implemented via respective computer program code and configured to compute a respective vector interface output (6) based on a respective vector interface input (5), wherein the target computation model (4) comprises a plurality of sub-models (7a, b, c) configured to compute a respective output quantity (14a, b, c) from a respective input quantity (15a, b, c), wherein a first set (9) of sub-models (7a, b) of the plurality consists of a respective neural network (8a, b), wherein a second set (11) of sub-models (7c) of the plurality consists of a respective analytic computation model (10), wherein an intermediate quantity (13a, b) is comprised by the output quantity (14a, b) of a sub-model (7a, b) of the first set (9), which intermediate quantity (13a, b) is comprised by the input quantity (15) of an interior sub-model (16), which interior sub-model (16) is comprised by the second set (11), wherein the system is configured to train the sub-models (7a, b) of the first set (9) through machine learning based on a plurality of vector training data sets, which plurality of vector training data sets conforms to the vector interface output (6) and the vector interface input (5) of the starting computation model (3).

# Fig. 1

Fig. 2

**EUROPEAN SEARCH REPORT**

Application Number

EP 22 17 5486

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KOCHKOV DMITRII ET AL: "Machine learning-accelerated computational fluid dynamics", PROCEEDINGS OF THE NATIONAL ACADEMY OF SCIENCES, vol. 118, no. 21, 18 May 2021 (2021-05-18), XP055981774, ISSN: 0027-8424, DOI: 10.1073/pnas.2101784118 * abstract * * figure 1 * * page 1 - page 4 * * the whole document * | 1-16 | INV. G06F30/27 G06N3/08 G06N5/00 G06N20/00 |
| X | ANIKESH PAL ET AL: "Using Deep Neural Networks as Cost-Effective Surrogate Models for Super-Parameterized E3SM Radiative Transfer", THE 3RD EAA EUROPEAN CONGRESS ON ACOUSTICS (FORUM ACUSTICUM 2002), JOHN WILEY & SONS, INC, SEVILLA, SPAIN, vol. 46, no. 11, 12 June 2019 (2019-06-12), pages 6069-6079, XP071443020, ISSN: 0094-8276, DOI: 10.1029/2018GL081646 * abstract * * sections 2.2, 3.2, 4 * * the whole document * | 1-16 | TECHNICAL FIELDS SEARCHED (IPC) G06F |
| A | CRABBE JONATHAN ET AL: "Learning outside the Black-Box: The pursuit of interpretable models", 34TH CONFERENCE ON NEURAL INFORMATION PROCESSING SYSTEMS (NEURIPS 2020), 31 December 2020 (2020-12-31), XP055981865, * abstract * * sections 2, 3, 4, 7 * * the whole document * | 7-13 | |

The present search report has been drawn up for all claims

| Place of search | Date of completion of the search | Examiner |
|---|---|---|
| Munich | 16 November 2022 | Joris, Pierre |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document